# EUROPEAN PATENT SPECIFICATION

(11) **EP 2 579 407 B1**
(45) Date of publication and mention of the grant of the patent: **25.11.2015**
(21) Application number: 12187266.7
(22) Date of filing: 04.10.2012
(51) Int. Cl.: H02G 3/08, H05K 7/02

(54) **Electric connection box**
Elektrischer Anschlusskasten
Coffret de connexion électrique

(30) Priority: 07.10.2011 JP 2011222506
(43) Date of publication of application: 10.04.2013
(73) Proprietor: Sumitomo Wiring Systems, Ltd., Yokkaichi-city, Mie 510-8503 (JP)
(72) Inventor: Yoshida, Ryohei, Yokkaichi-city, Mie 510-8503 (JP); Shimada, Yoshihisa, Yokkaichi-city, Mie 510-8503 (JP)
(74) Representative: Winter, Brandl, Fürniss, Hübner, Röss, Kaiser, Polte - Partnerschaft mbB

(56) References cited:
- AU-A- 4 511 072
- US-A- 5 097 592
- US-B1- 6 560 840

## Description

The present invention relates to an electric connection box installed to an automobile or the like, and more particularly, to an electric connection box including a hollow case formed by fitting one case and the other case together and an internal circuit body housed within the hollow case.

An electric connection box in the related art adopts a configuration in which a hollow case is formed by fitting one case and the other case, such as an upper case and a lower case, to each other on the sides of opening portions and an internal circuit body formed of bus bars and the like is housed within the hollow case. With the electric connectioh box configured as above, by positioning the one case and the other case precisely with respect to each other and fitting the both cases together, connection terminals provided to the internal circuit body protrude in component attachment portions, such as fuses, relays, and connectors, provided on an outer surface of the hollow case via terminal insertion holes provided to penetrate through the hollow case.

For the positioning of the one case and the other case with respect to each other, there has been proposed a structure in which, as are shown in Fig. 2, Fig. 3, Fig. 10, and Fig. 12 of JP-A-2010-110060, positioning bosses protruding toward the other case are provided to an interior of the one case and positioning recesses opening toward the one case are provide to an interior of the other case. When configured in this manner, the other case is positioned precisely with respect to the one case by allowing the positioning bosses to be fit into the positioning recesses. Accordingly, connection terminals of the internal circuit body housed in the one case are precisely guided to and inserted into the terminal insertion holes provided to penetrate through the other case. It thus becomes possible to smoothly fit the one case and the other case together.

Incidentally, the hollow case of the electric connection box is of substantially a rectangular shape in many cases in consideration that the hollow case houses the internal circuit body or the like while the hollow case is installed in an engine room or a passenger component. The one case and the other case each of substantially a rectangular shape forming such a hollow case of a rectangular shape may possibly be fit together erroneously when the cases are accidentally rotated by 180° with respect to each other during an assembling work. In order to avoid this inconvenience, a structure as is described in JP-A-2010-110060 has been proposed. That is, several pairs of positioning bosses and positioning recesses are provided randomly at intermediate positions asymmetrical with respect to a center axis of the hollow case. Hence, in a case where the one case and the other case are accidentally rotated by 180° with respect to each other from a normal fitting direction and forced to fit together, the positioning bosses interfere with the other case. Assembling is thus inhibited.

However, demands of a size reduction and space saving for the electric connection box in recent years make it difficult to provide several pairs of positioning bosses and positioning recesses at intermediate positions in the electric connection box as in the structure in the related art. To date, a specific structure capable of advantageously preventing erroneous assembling of an electric connection box while satisfying demands of a size reduction and space saving as above has not been proposed.

The invention was devised in view of the foregoing circumstances and has an object to provide an electric connection box of a novel structure capable of providing a structure of positioning one case and the other case with respect to each other and a structure preventing erroneous assembling while achieving a size reduction and space saving.

According to a first aspect of the invention, an electric connection box is configured in such a manner that an internal circuit body is housed within a rectangular hollow case formed by fitting one case and an other case together and the one case and the other case are positioned with respect to each other by fitting a positioning boss provided to an interior of the one case into a positioning recess provided to an interior of the other case. The electric connection box is **characterized in that**: the positioning boss and the positioning recess are provided in each of a first corner portion and a second corner portion opposing in a direction of a diagonal line of the hollow case; an inside dimension in the direction of the diagonal line of the positioning recess provided in the second corner portion is set larger than an inside dimension in the direction of the diagonal line of the positioning recess provided in the first corner portion; a rib protrusion protruding in the direction of the diagonal line is provided on an outer peripheral surface of the positioning boss provided in the second corner portion; a fitting recess groove in which the rib protrusion is fit into is provided to the positioning recess provided in the second corner portion; and the positioning recess provided in the first corner portion is provided with an inner protrusion protruding inward in the direction of the diagonal line and allowed to interfere with the rib protrusion.

In the electric connection box of the structure according to the invention, the positioning boss and the positioning recess are provided in a pair of the first corner portion and the second corner portion opposing in a direction of a single diagonal line of the hollow case of a rectangular shape. The corner portions of the hollow case are often left unused because it is difficult to install electrical components. Hence, by successfully utilizing such an unused region, it becomes possible to provide the positioning bosses and the positioning recesses at high efficiency of space utilization.

The positioning boss and the positioning recess are provided in each of the first corner portion and the second corner portion opposing in the direction of the diagonal line. Hence, for example, by fitting the positioning boss into the positioning recess in the second corner portion after the one case and the other case are positioned with respect to each other in the first corner by fitting the positioning boss into the positioning recess in the first corner portion, even when there is a dimensional error of the respective cases, it becomes possible to reliably fit the positioning boss into the positioning recess in each of the first corner portion and the second corner portion by successfully using the property that deformation can take place easily in the direction of the diagonal line of the cases of a rectangular shape. It thus becomes possible to perform a work to fit the one case and the other case together easily.

In particular, the inside dimension in the direction of the diagonal line of the positioning recess provided in the second corner portion is set larger than the inside dimension in the direction of the diagonal line of positioning recess provided in the first corner portion. Consequently, in a case where the positioning boss is fit into the positioning recess in the second corner portion after the positioning boss is fit into the positioning recess in the first corner portion temporarily, it becomes further easier to absorb a dimensional error in the positioning recess in the second corner portion provided to have a larger inside dimension. Accordingly, when dimensions of the one case and the other case are designed, it becomes possible to more favourably achieve an advantage that a dimensional error can be absorbed by setting the first corner portion as the reference position.

In addition, the rib protrusion protruding in the direction of the diagonal line is provided on the outer peripheral surface of the positioning boss provided in the second corner portion and the fitting recess groove in which the rib protrusion is fit into is provided to the positioning recess in the second corner portion. Meanwhile, the inner protrusion capable of interfering with the rib protrusion is provided to the positioning recess of the first corner portion. Owing to this configuration, the positioning boss is allowed to be fit into the positioning recess at the normal fitting position as the rib protrusion of the positioning boss in the second corner portion is fit into the fitting recess groove of the positioning recess in the second corner portion. In contrast, at a non-normal fitting position at which the one case and the other case are rotated by 180° with respect to each other, the rib protrusion of the positioning boss in the second corner portion interferes with the inner protrusion of the positioning recess in the first corner portion and fitting is inhibited. Consequently, it becomes possible to advantageously prevent erroneous assembling in a state where the cases are inverted by 180° with respect to each other, which occurs often because the cases are of a rectangular shape. Hence, it becomes possible to forestall damage on the connection terminals or the like caused by erroneous assembling. In particular, the rib protrusion of the positioning boss in the second corner portion is housed in the positioning recess in the second corner portion by successfully using a space whose inside dimension in the direction of the diagonal line is set larger. It thus becomes possible to provide a structure capable of making assembling further easier and achieving an advantage of preventing erroneous assembling at the same time with excellently high efficiency of space utilization. It should be noted that the rib protrusion includes those protruding from the outer surface of the positioning boss to only one side in the direction of the diagonal line of the hollow case and those protruding to the both sides in the direction of the diagonal line.

Preferably, the electric connection box according to the present invention is configured in such a manner that: the positioning recess provided in the first corner portion extends in a circular shape in cross section; the positioning recess provided in the second corner portion extends in an elliptical shape in cross section having a long axis extending in the direction of the diagonal line; and the positioning boss extends in a cylindrical shape having an outside diameter smaller than the cross section of the circular shape of the positioning recess provided in the first corner portion.

With regard to shapes of the positioning boss and the positioning recess of the invention, an arbitrary shape, such as a rectangular shape and a polygonal shape, can be adopted suitably. In particular, according to this aspect, the positioning recess in the first corner portion is of a circular shape in cross section and the positioning recess in the second corner portion is of an elliptical shape in cross section while the positioning boss is of a cylindrical shape. Hence, because no corner is provided to surfaces forming the positioning boss and the positioning recess, it becomes possible to fit the positioning boss into the positioning recess at the normal fitting position further smoothly. Also, it becomes possible to further effectively exert an advantage that a dimensional error of the cases can be absorbed in the second corner portion.

According to the invention, the positioning boss and the positioning recess are provided in each of the first corner portion and the second corner portion opposing in the direction of the diagonal line of the hollow case and the inside dimension in the direction of the diagonal line of the positioning recess in the second corner portion is set larger than the inside dimension in the direction of the diagonal line of the positioning recess in the first corner portion. Consequently, it becomes possible to absorb a dimensional error between the both cases by successfully utilizing the property that deformation can take place in the direction of the diagonal line of the cases. Hence, it becomes possible to fit the positioning boss into the positioning recess in a reliable manner in each of the first corner portion and the second corner portion. Further, the rib protrusion of the positioning boss in the second corner portion is allowed to be fit into the fitting recess groove of the positioning recess in the second corner portion while being allowed to interfere with the inner protrusion of the positioning recess in the first corner portion. Consequently, the positioning boss in the second corner portion is allowed to be fit into the positioning recess in the second corner portion alone. It thus becomes possible to prevent the both cases from being fit together erroneously. Also, the positioning boss and the positioning recess are formed in a pair of the corner portions of the cases that are often left as an unused region. Hence, the positioning structure and the erroneous assembling preventing structure can be provided with high efficiency of space utilization.

The invention now will be more fully described by means of an illustrative but not limiting embodiment thereof in conjunction with the accompanying drawings, in which:

Fig. 1 is an exploded perspective view of an electric connection box according to one embodiment of the invention;
Fig. 2 is a bottom view of a lower case;
Fig. 3 is a plan view of the lower case;
Fig. 4 is a side view of the lower case;
Fig. 5(a) is an enlarged view of a first positioning recess and Fig. 5(b) is a cross section taken along the line Vb-Vb of Fig. 5(a);
Fig. 6(a) is an enlarged view of a second positioning recess and Fig. 6(b) is a cross section taken along the line Vlb-Vlb of Fig. 6(a);
Fig. 7 is a bottom view of an upper case;
Fig. 8 is a side view of the upper case;
Fig. 9 is an enlarged view of a first positioning boss;
Fig. 10 is an enlarged view of a second positioning boss;
Fig. 11 is a cross section taken along the line XI-XI of Fig. 2 of the electric connection box shown in Fig. 1 in an assembled state;
Fig. 12(a) is a view used to describe a fit-in state of the first positioning boss in the first positioning recess and Fig. 12(b) is a view used to describe a fit-in state of the second positioning boss in the second positioning recess; and
Fig. 13 is a view used to describe a case where the second positioning boss is forced to fit in the first positioning recess.

Hereinafter, an embodiment of the invention will be described with reference to the drawings.

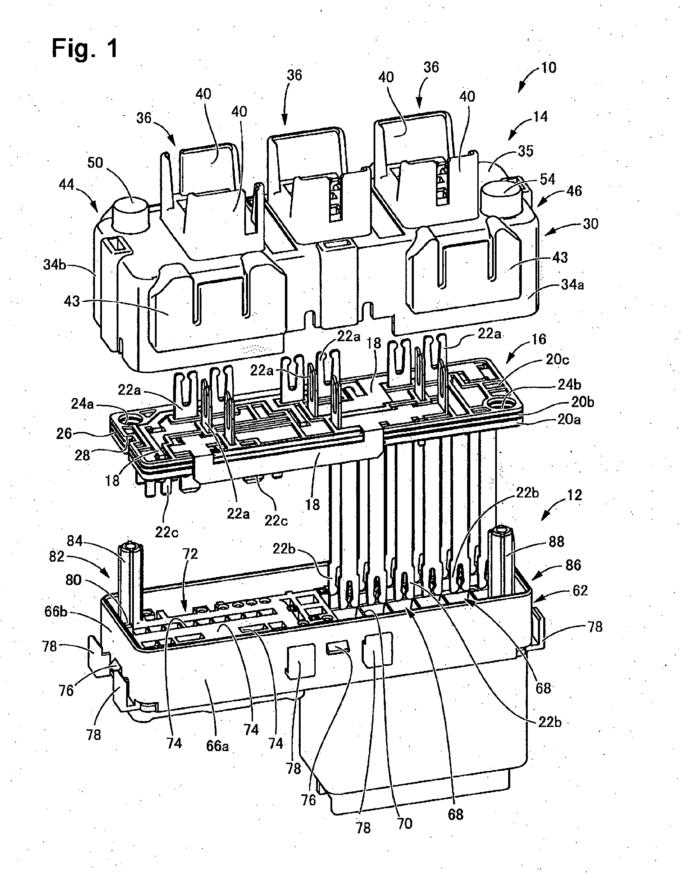

Firstly, Fig. 1 shows an electric connection box 10 as a possible embodiment of the invention. The electric connection box 10 is of a structure in which an upper case 12 as one case and a lower case 14 as the other case are fit to each other with a bus bar circuit 16 as an internal circuit body being housed within.

The bus bar circuit 16 is of a structure in which a plurality of bus bars 18 and a plurality of (herein, three) insulating plates 20a through 20c are laminated. As in the related art, connection terminals 22a of a so-called tuning fork shape formed of a pair of opposing insulation displacement blades to connect to unillustrated relays as electrical components, connection terminals 22b of substantially the same tuning fork shape as the connection terminals 22a to connect to unillustrated fuses as electrical components, connection terminals 22c of substantially a rectangular plate shape to connect to unillustrated connectors as electrical components, and the like are appropriately provided at end portions of the bus bars 18. The connection terminals 22a protrude toward the lower case 14 (upward in Fig. 1) in a lamination direction of the laminated insulating plates 20a through 20c whereas the connection terminals 22b and 22c protrude toward the upper case 12 (downward in Fig. 1) in the lamination direction of the insulating plates 20a through 20c. A protrusion dimension of the connection terminals 22b from the insulating plates 20a through 20c is greater than a protrusion dimension of the connection terminals 22c protruding in the same direction.

The respective insulating plates 20a through 20c are of substantially a longitudinal rectangular plate shape all in equal size. Each of the insulating plates 20a through 20c is provided with a first insertion hole 24a and a second insertion hole 24b penetrating through the plate in a pair of diagonally located corners. The first insertion hole 24a and the second insertion hole 24b are of substantially the same shapes, respectively, as a first positioning recess 45 and a second positioning recess 48 described below. When the respective insulating plates 20a through 20c are laminated one on another, the first through holes 24a and the second through-holes 24b provided to the respective insulating plates 20a through 20c coincide with one another and thereby form through-holes penetrating through the insulating plates 20a through 20c in the lamination direction. Further, the respective insulating plates 20a through 20c are provided with positioning notches 28 at substantially center portions of edge portions 26 forming short sides all on the same side. As the positioning notches 28 of the respective insulating plates 20a through 20c are brought into coincidence with one another, a notch penetrating through the insulating plates 20a through 20c in the lamination direction is formed.

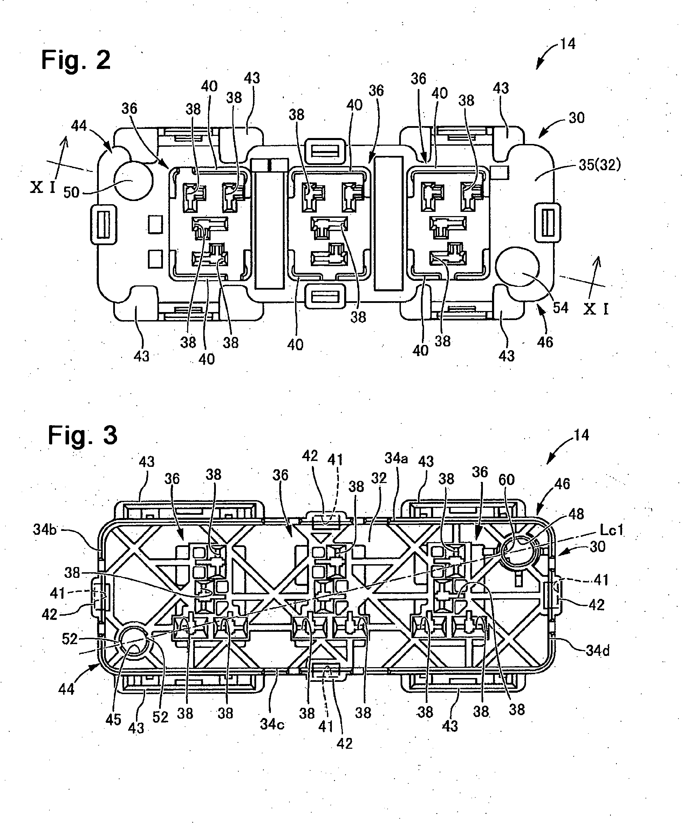

Fig. 2 through Fig. 4 show the lower case 14. The lower case 14 is a single-piece article made of synthetic resin. The lower case 14 is provided with a case main body 30 of substantially a longitudinal rectangular box shape opening toward the upper case 12. The case main body 30 is formed of a bottom plate 32 of substantially a longitudinal rectangular shape and a circumferential wall 34 protruding toward the upper case 12 from an outer peripheral edge portion of the bottom plate 32. Consequently, when viewed in a direction in which the lower case 14 is fit to the upper case 12 (see Fig. 2), the lower case 14 as a whole is of substantially a rotationally symmetric longitudinal rectangular shape. In addition, a surface of the bottom plate 32 on the outside of the case main body 30 forms an outer surface 35 of the lower case 14.

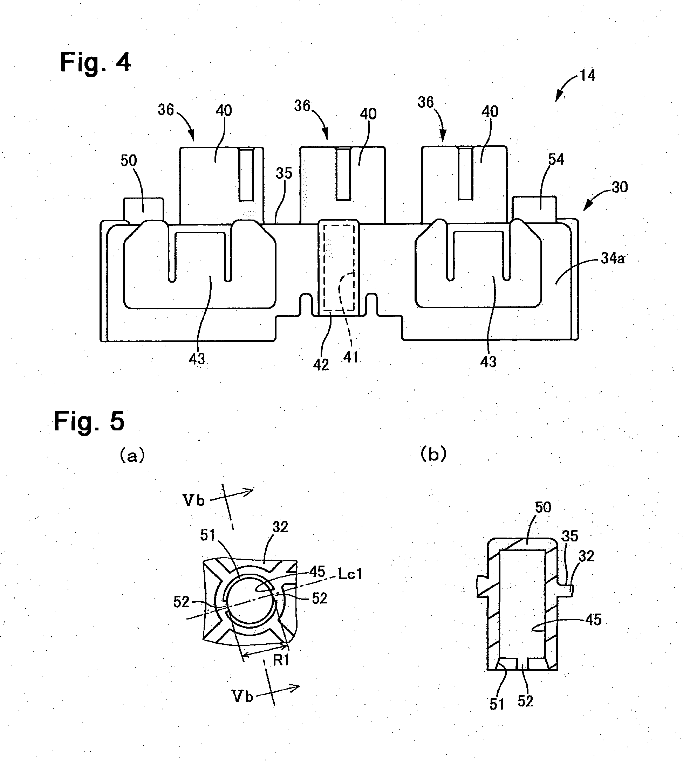

The lower case 14 is provided with a plurality of (herein, three) relay attachment portions 36 aligned side by side in a longitudinal direction (left-right direction in Fig. 2). In each relay attachment portion 36, terminal insertion holes 38 in which the connection terminals 22a of the bus bars 18 are inserted are provided so as to penetrate through the bottom plate 32. Each relay attachment portion 36 is formed to protrude outward (upward in Fig. 4) on the outside of the case main body 30 from the bottom plate 32. Each relay attachment portion 36 is provided with a pair of opposing protection wall portions 40 and 40 each protruding outward on the outside of the case main body 30 from the bottom plate 32.

Also, as are shown in Fig. 3 and Fig. 4, the circumferential wall 34 of a longitudinal rectangular shape is formed of circumferential walls 34a and 34c forming long sides and circumferential walls 34b and 34d forming short sides. An engaging recess 41 that becomes concave inward on the inside of the case main body 30 is provided at a center portion of an inner surface of each circumferential wall. Consequently, a locking portion 42 protruding inward on the inside of the case main body 30 from the engaging recess 41 is formed relatively in an outer peripheral portion of the engaging recess 41 on the side of the upper case 12. Further, a pair of locking portions 43 and 43 are provided on the outer surfaces of the circumferential walls 34a and 34c on the both sides having the engaging recess 41 in between. Owing to these locking portions 43 and 43, it becomes possible to fix the electric connection box 10 to unillustrated another electric connection box, an unillustrated vehicle body panel, or the like.

As is shown in Fig. 3, in the interior of the lower case 14, the first positioning recess 45 as a positioning recess is formed in a first corner portion 44, which is one of corners opposing in a direction of a diagonal line Lc1 on the bottom plate 32 of substantially a longitudinal rectangular shape, and the second positioning recess 48 as a positioning recess is formed in a second corner portion 46, which is the other corner. As is also shown in Fig. 5, the first positioning recess 45 is defined by a center hole of a first tube body 50 as a tube body of a bottomed cylindrical shape opening toward the upper case 12 (lower side in Fig. 5B) and formed in the first corner portion 44 of the bottom plate 32. The first positioning recess 45 is of a concave shape extending in a direction in which the lower case 14 and the upper case 12 are fit together (top-bottom direction in Fig. 5B) in substantially a true circular shape in cross section.

In an opening edge portion of the first positioning recess 45 on the side of the upper case 12, a taper portion 51 expanding toward the upper case 12 is formed continuously along substantially the entire circumference except for inner protrusions 52 and 52 described below. Further, a pair of the inner protrusions 52 and 52 protruding inward on the inside of the first positioning recess 45 in the direction of the diagonal line Lc1 are provided to the opening edge portion of the first positioning recess 45 on the side of the upper case 12. The inner protrusions 52 and 52 are located oppositely in the diagonal direction Lc1 of the bottom plate 32 and formed in a protruding shape in the opening edge portion of the first positioning recess 45 where the taper portion 51 is provided. Consequently, an inside dimension R1 of the first positioning recess 45 in the direction of the diagonal line Lc1 is defined by a spacing distance between the inner protrusions 52 and 52 in the direction of the diagonal line Lc1. The spacing distance between the inner protrusions 52 and 52 is equal to a diameter dimension (dimension in the left-right direction in Fig. 5B) of the first positioning recess 45 in a portion where the taper portion 51 is not formed and therefore not expanded in diameter by the taper portion 51.

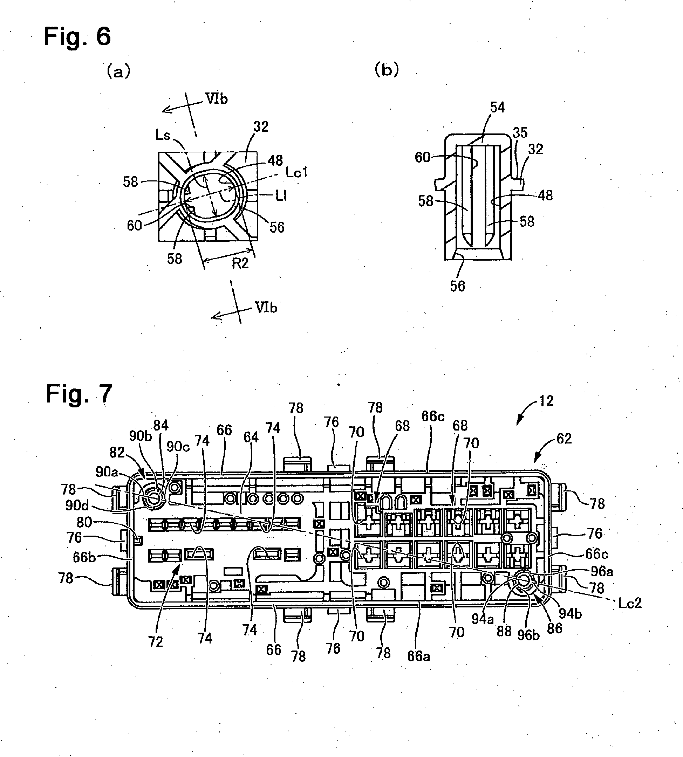

Meanwhile, as is also shown in Fig. 6, the second positioning recess 48 is defined by a center hole of a second tube body 54 as a tube body of a bottomed tube shape opening toward the upper case 12 (lower end in Fig. 6(b)) and provided in a second corner portion 46 (see Fig. 3) oppositely to the first tube portion 50 in the direction of the diagonal line Lc1 of the bottom plate 32. The second positioning recess 48 is of a concave shape extending in a direction in which the lower case 14 and the upper case 12 are fit together (top-bottom direction in Fig. 6(b)) in substantially an elliptical shape in cross section having a long axis LI and a short axis Ls. The long axis LI extends in the direction of the diagonal line Lc1. Consequently, an inside dimension R2 of the second positioning recess 48 in the direction of the diagonal line Lc1 is defined by the long axis LI and set larger than the inside dimension R1 of the first positioning recess 45 in the direction of the diagonal line Lc1.

In an opening edge portion of the second positioning recess 48 on the side of the upper case 12, a taper portion 56 expanding toward the upper case 12 is formed continuously along the entire circumference of the second positioning recess 48. Further, a pair of guide ribs 58 and 58 are provided on an inner peripheral surface of the second positioning recess 48 so as to protrude inward on the inside of the second positioning recess 48 and extend in an extending direction of the second positioning recess 48 (top-bottom direction in Fig. 6(b)). The guide ribs 58 and 58 are spaced apart in a circumferential direction of the second positioning recess 48. Consequently, a fitting recess groove 60 extending in the extending direction of the second positioning recess 48 is formed between the guide ribs 58 and 58. The fitting recess groove 60 is located on the side of the first corner portion 44 (lower left in Fig. 6(a)) on the long axis LI of the second positioning recess 48. Consequently, as is shown in Fig. 3, the fitting recess groove 60 and a pair of the inner protrusions 52 and 52 of the first positioning recess 45 are located in a straight line on the diagonal line Lc1.

The first tube body 50 and the second tube body 54 respectively forming the first positioning recess 45 and the second positioning recess 48 are provided, respectively, in the first corner portion 44 and the second corner portion 46 located in opposing corners of the bottom plate 32 of a longitudinal rectangular shape and therefore spaced apart from each other. The first tube body 50 and the second tube body 54 are also provided to protrude outward (upward in Fig. 4) on the outside of the case main body 30 from the outer surface 35 of the bottom plate 32. Protrusion dimensions of the first positioning recess 45 and the second positioning recess 48 from the outer surface 35 are substantially equal to each other and set smaller than a protrusion dimension of the protecting wall portions 40 of the relay attachment portions 36. Also, as is shown in Fig. 2, the first tube body 50 corresponds to a shape of the first positioning recess 45 of substantially a true circular shape and is therefore of substantially a true circular shape when viewed in a direction in which the lower case 14 is fit to the upper case 12 (see Fig. 2). Meanwhile, the second tube body 54 corresponds to a shape of the second positioning recess 48 of substantially an elliptical shape and is therefore of substantially an elliptical shape when viewed in the direction in which the lower case 14 is fit to the upper case 12. In this manner, the first tube body 50 and the second tube body 54 have outer shapes different from each other when viewed in the direction in which the lower case 14 is fit to the upper case 12.

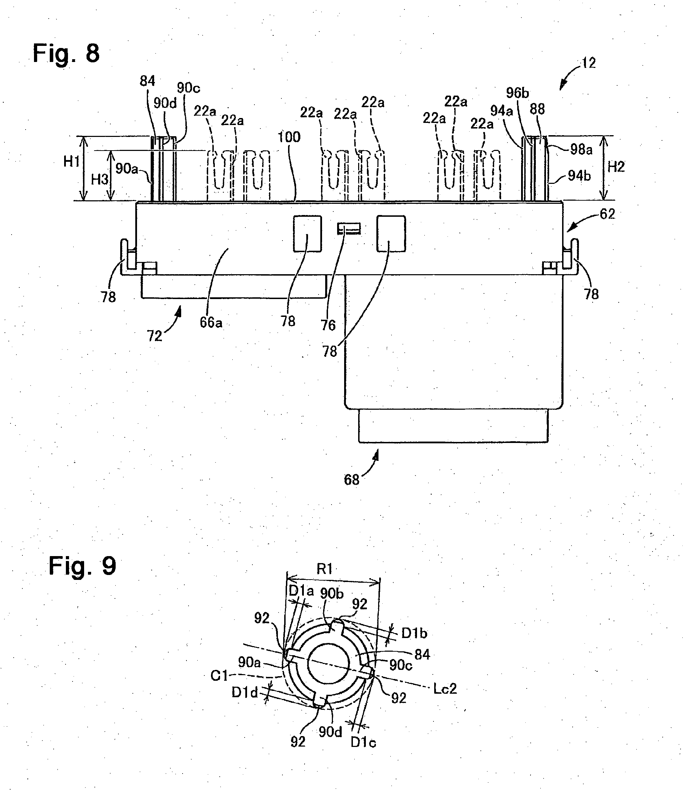

Fig. 7 and Fig. 8 show the upper case 12. The upper case 12 is a single-piece article made of synthetic resin. The upper case 12 is provided with a case main body 62 of substantially a longitudinal rectangular box shape opening toward the lower case 14 (upper side in Fig. 8). The case main body 62 is formed of a top plate 64 of substantially a longitudinal rectangular shape and a circumferential wall 66 protruding toward the lower case 14 from an outer peripheral edge portion of the top plate 64. Consequently, when viewed in the direction in which the upper case 12 is fit to the lower case 14 (see Fig. 7), the upper case 12 as a whole is of substantially a rotational symmetric longitudinal rectangular shape. The top plate 64 of the upper case 12 is formed slightly smaller than the bottom plate 32 of the lower case 14 so that the circumferential wall 66 of the upper case 12 is internally inserted into the circumferential wall 34 of the lower case 14.

The top plate 64 of the upper case 12 is provided with a plurality of (herein, six) fuse attachment portions 68 aligned side by side in a longitudinal direction (left-right direction in Fig. 7). In each fuse attachment portion 68, a pair of terminal insertion holes 70 and 70 in which a pair of the connection terminals 22b and 22b of the bus bars 18 are inserted are provided so as to penetrate through the top plate 64 and oppositely. Also, the top plate 64 is provided with a single connector attachment portion 72.adjacently to a plurality of the fuse attachment portions 68 in the longitudinal direction of the top plate 64. In the connector attachment portion 72, a plurality of terminal insertion holes 74 in which a plurality of the connection terminals 22c of the bus bars 18 are inserted are provided so as to penetrate through the top plate 64. The terminal insertion holes 74 are aligned in two rows in the longitudinal direction of the top plate 64. The fuse attachment portions 68 of the electric connection box 10 of this embodiment considerably protrude outward (downward in Fig. 8) on the outside of the case main body 62 from the top plate 64.

Also, the circumferential wall 66 of a longitudinal rectangular shape is formed of circumferential walls 66a and 66c forming long sides and circumferential walls 66b and 66d forming short sides. A locking claw 76 is provided to protrude at a center of the outer surface of each circumferential wall. Also, a pair of pinching pieces 78 and 78 of a hook shape opening toward the lower case 14 are provided to each of the circumferential walls 66a through 66d on the both sides having the locking claw 76 in between. Further, a positioning protrusion 80 of a size matching the positioning notches 28 provided to the insulating plates 20a through 20c of the bus bar circuit 16 is provided on the inner surface of the circumferential wall 66b so as to protrude inward on the inside of the case main body 62.

In the interior of the upper case 12, a first positioning boss 84 as a positioning means is provided in a first corner portion 82 of the top plate 64 of substantially a longitudinal rectangular shape. The first corner portion 82 coincides with the first corner portion 44 of the lower case 14 (see Fig. 3) when the upper case 12 and the lower case 14 are fit together. Also, in the interior of the upper case 12, a second positioning boss 88 as a positioning means is provided in a second corner portion 86 opposing the first corner portion 82 in a direction of a diagonal line Lc2 of the top plate 64. The second corner portion 86 coincides with the second corner portion 46 of the lower case 14 when the upper case 12 and the lower case 14 are fit together. Consequently, the first positioning boss 84 and the second positioning boss 88 are provided to the top plate 64 at locations spaced apart from each other diagonally.

The first positioning boss 84 provided in the first corner portion 82 is of substantially a cylindrical shape protruding from the top plate 64 toward the lower case 14 (upper side in Fig. 8) while maintaining substantially a constant outside diameter dimension. As is shown in Fig. 9, a plurality of rattling preventing ribs 90 are provided on an outer peripheral surface of the first positioning boss 84. The rattling preventing ribs 90 are provided at regular intervals in a circumferential direction and to protrude radially outward on the outside of the first positioning boss 84. In this embodiment, four rattling preventing ribs 90a through 90d are provided in every 90° about a center axis of the first positioning boss 84. A pair of the rattling preventing ribs 90a and 90c are provided on the outside of the first positioning boss 84 on the both sides in a radial direction to protrude in the direction of the diagonal line Lc2. Protrusion dimensions D1a through D1d of the rattling preventing ribs 90a through 90d, respectively, from the outer peripheral surface of the first positioning boss 84 are all set to be equal. Protrusion tip edge portions of the rattling preventing ribs 90a through 90d from the outer peripheral surface of the first positioning boss 84 are set to a size allowing the protrusion tip edge portions to be inscribed in a circle C1 having a diameter of R1 and corresponding to a sectional shape of the first positioning recess 45. Consequently, the first positioning boss 84 extends from the top plate 64 in a cylindrical shape having an outside diameter smaller than the inside dimension R1 of the first positioning recess 45 in a portion where the rattling ribs 90a through 90d are not provided. In addition, the rattling preventing ribs 90a through 90d are provided substantially fully along the first positioning boss 84 in an extending direction (top-bottom direction in Fig. 8). As is shown in Fig. 9, a taper surface 92 is provided to each of the protrusion tip edge portions of the respective rattling preventing ribs 90a through 90d from the top plate 64. A protrusion dimension of the taper surface 92 from the outer peripheral surface of the first positioning boss 84 reduces gradually toward the tip end in the protruding direction (upward in Fig. 8). It thus becomes easy to insert the first positioning boss 84 into the first positioning recess 45.

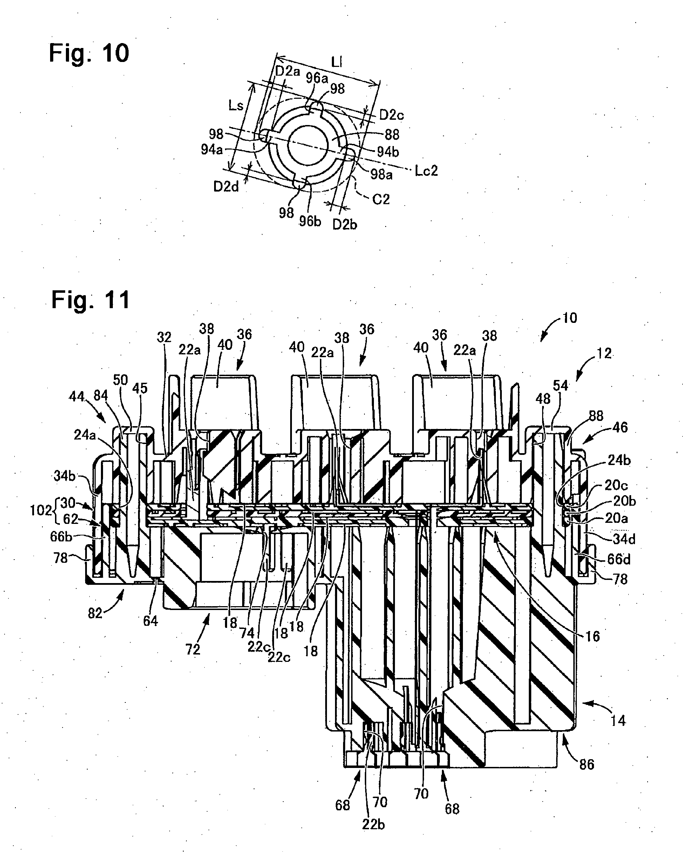

Meanwhile, the second positioning boss 88 provided in the second corner portion 86 protrudes toward the lower case 14 (upper side in Fig. 8) from the top plate 64 in substantially a cylindrical shape having an outside diameter dimension substantially equal to that of the first positioning boss 84. As is shown in Fig. 10, a pair of rib protrusions 94a and 94b and a pair of rattling preventing ribs 96a and 96b each protruding radially outward on the outside of the second positioning boss 88 are provided on an outer peripheral surface of the second positioning boss 88 at predetermined intervals in the circumferential direction. In this embodiment, the rib protrusions 94a and 94b and the rattling preventing ribs 96a and 96b are provided alternately in every 90° about a center axis of the second positioning boss 88. The rib protrusions 94a and 94b are provided on the outside of the second positioning boss 88 on the both sides in a radial direction to protrude in the direction of the diagonal line Lc2. Also, the rattling preventing ribs 96a and 96b are provided on the outside of the second positioning boss 88 on the both sides in a radial direction to protrude in a direction orthogonal to the diagonal line Lc2. Consequently, as is shown in Fig. 7, the rib protrusions 94a and 94b of the second positioning rib 88 and the rattling preventing ribs 90a and 90c of the first positioning boss 84 are provided in a straight line on the diagonal line Lc2. Protrusion dimensions D2a and D2b of the rib protrusions 94a and 94b, respectively, from the outer peripheral surface of the second positioning boss 88 are set to be equal to each other. Also, protrusion dimensions D2c and D2d of the rattling preventing ribs 96a and 96b, respectively, from the outer peripheral surface of the second positioning boss 88 are set to be equal to each other. The protrusion dimensions D2a and D2b of the rib protrusions 94a and 94b, respectively, are set larger than the protrusion dimensions D2c and D2d of the rattling preventing ribs 96a and 96b, respectively. Consequently, the protrusion tip edge portions of the rattling preventing ribs 96a and 96b are inscribed in an oval C2 having a long axis LI and a short axis Ls and corresponding to a sectional shape of the second positioning recess 48 in a direction of the short axis Ls. Meanwhile, the protrusion tip edge portions of the rib protrusions 94a and 94b are set to a size to be located on slightly inner side from the oval C2 in a direction of the long axis LI.

Also, the rib protrusions 94a and 94b and the rattling preventing ribs 96a and 96b are formed substantially fully along the second positioning boss 88 in an extending direction (top-bottom direction in Fig. 8). As is shown in Fig. 10, a taper surface 98 is provided to each of the protrusion tip edge portions of the respective rib protrusions 94a and 94b and rattling preventing ribs 96a and 96b from the top plate 64. A protrusion dimension of the taper surface 98 from the outer peripheral surface of the second positioning boss 88 reduces gradually toward the tip end in the protruding direction (upward in Fig. 8). It thus becomes easy to insert the second positioning boss 88 into the second positioning recess 48. In particular, the taper surface 98a of the rib protrusion 94b located on the outer side of the upper case 12 in the direction of the diagonal line Lc2 is formed longer than the other taper surfaces 98 of the rib protrusion 94a and the rattling preventing ribs 96a and 96b in the extending direction of the second positioning boss 88 (top-bottom direction in Fig. 8). Hence, this taper surface 98 starts to exert a guiding function on the second positioning recess 48 in an outer portion of the second positioning boss 88 in the direction of the diagonal line Lc2 in an early stage. It thus becomes possible to more effectively absorb a dimensional error between the upper case 12 and the lower case 14.

As is shown in Fig. 8, protrusion heights H1 and H2 of the first positioning boss 84 and the second positioning boss 88, respectively, from a tip end portion 100 of the circumferential wall 66 toward the lower case 14 (upper side in Fig. 8) are set to sizes equal to each other. In a state where the bus bar circuit 16 is housed in the upper case 12, the protrusion heights H1 and H2 of the first positioning boss 84 and the second positioning boss 88, respectively, are set larger than a protrusion height H3 of the connection terminals 22a of the bus bar circuit 16 from the tip end portion 100 toward the lower case 14.

When the electric connection box 10 as above is assembled, as is shown in Fig. 1, a plurality of the bus bars 18 and a plurality of the insulating plates 20a through 20c are laminated first to form the bus bar circuit 16. Subsequently, the upper case 12 is located vertically below the bus bar circuit 16. The connection terminals 22b and 22c protruding from the insulating plate 20a of the bus bar circuit 16 are inserted, respectively, into the terminal insertion holes 70 and 74 of the upper case 12. Also, the first positioning boss 84 and the second positioning boss 88 are inserted, respectively, into the first insertion holes 24a and the second insertion holes 24b of the insulating plates 20a through 20c. The insulating plates 20a through 20c are thus housed within the case main body 62 of the upper case 12. The insulating plates 20a through 20c can be positioned with accuracy within the case main body 62 as the positioning notches 28 and the positioning protrusion 80 of the upper case 12 are engaged with each other. Subsequently, the lower case 14 is placed on the upper case 12 from above in a vertical direction, so that the first positioning boss 84 of the upper case 12 is fit into the first positioning recess 45 of the lower case 14 while the second positioning boss 88 is fit into the second positioning recess 48. Hence, the lower case 14 is positioned with respect to the upper case 12 and placed thereon. Consequently, the upper case 12 and the lower case 14 are fit together in such a manner that the circumferential wall 34 of the lower case 14 is inserted on the outer peripheral side of the circumferential wall 66 of the upper case 12 while the circumferential wall 34 of the lower case 14 is pinched between the pinching pieces 78 and the circumferential wall 66 of the upper case 12. Then, the locking claws 76 of the upper case 12 go into the engaging recesses 41 formed in the inner surface of the circumferential wall 34 of the lower case 14. Then, as the locking portions 42 on the outer peripheral side of the engaging recesses 41 and the locking claws 76 are engaged with each other, the upper case 12 and the lower case 14 are fit to each other in a locked state. The electric connection box 10 is thus formed.

As is shown in Fig. 11, the hollow case 102 of a rectangular shape is formed by fitting the case main body 62 of the upper case 12 and the case main body 30 of the lower case 14 both of a longitudinal rectangular box shape to each other while the upper case 12 and the lower case 14 are fit to each other. The bus bar circuit 16 is housed in the interior of the hollow case 102 while the insulating plates 20a through 20c of the bus bar circuit 16 are sandwiched between the upper case 12 and the lower case 14. Consequently, the connection terminals 22a of the bus bar circuit 16 are inserted into the terminal insertion holes 38 of the relay attachment portions 36 to protrude into an outside space of the hollow case 102 while the connection terminals 22b and 22c are inserted, respectively, into the terminal insertion holes 70 of the fuse attachment portions 68 and the terminal insertion holes 74 of the connector attachment portion 72 to protrude into the outside space of the hollow case 102.

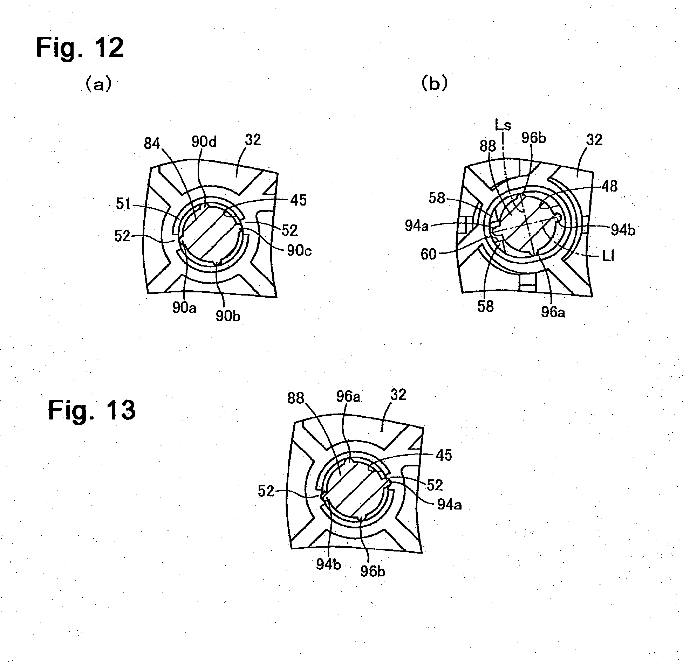

Also, as is shown in Fig. 12(a), the first positioning boss 84 is inserted into the first positioning recess 45 in such a manner that there is substantially no clearance between the four rattling preventing ribs 90a through 90d and the inner peripheral surface of the first positioning recess 45. Meanwhile, as is shown in Fig. 12(b), the second positioning boss 88 is positioned in the circumferential direction by the rib protrusions 94a and 94b as the rib protrusion 94a located on the inner side of the hollow case 102 in the direction of the diagonal line Lc2 (see Fig. 7) is fit into the fitting recess groove 60. Then, the rattling preventing ribs 96a and 96b are located in the direction of the short axis Ls of the second positioning recess 48. Hence, the second positioning boss 88 is inserted into the second positioning recess 48 in such a manner that there is substantially no clearance between the rattling preventing ribs 96a and 96b and the inner peripheral surface of the second positioning recess 48. On the other hand, the rib protrusion 94a and 94b are located in the direction of the long axis LI of the second positioning recess 48, which is the direction of the diagonal line Lc2. Hence, the second positioning boss 88 is inserted into the second positioning recess 48 in such a manner that there is a slight clearance between the rib protrusions 94a and 94b and the inner peripheral surface of the second positioning recess 48.

In the electric connection box 10 of the structure according to this embodiment, the positioning bosses 84 and 88 and the positioning recesses 45 and 48 used to position the upper case 12 and the lower case 14 with respect to each other are provided, respectively, in the first corner portions 44 and 82 and the second corner portions 46 and 86 located at opposing corners of the hollow case 102. Hence, when the second positioning boss 88 is fit into the second positioning recess 48 after the first positioning boss 84 is fit into the first positioning recess 45 temporarily, it becomes possible to absorb a dimensional error between the upper case 12 and the lower case 14 using the property that deformation takes place easily in a direction of the diagonal line of the upper case 12. In particular, the second positioning recess 48 is formed in an elliptical shape having the long axis L1 (see Fig. 6) in the direction of the diagonal line Lc1 of the hollow case 102 and the inside dimension R2 in the direction of the diagonal line Lc1 is set larger than the inside dimension R1 of the first positioning recess 45 in the direction of the diagonal line Lc1. Consequently, it becomes possible to secure a clearance between the second positioning recess 48 and the second positioning boss 88 in the direction of the diagonal line Lc1. Hence, it becomes possible to more effectively exert an advantage that a dimensional error can be absorbed in the direction of the diagonal line.

Further, as is shown in Fig. 12(b), in a case where the second positioning boss 88 is inserted into the second positioning recess 48, the second positioning boss 88 is allowed to be inserted into the second positioning recess 48 as the rib protrusion 94a of the second positioning boss 88 is fit into the fitting recess groove 60 in the second positioning recess 48. In contrast, for example, in a case where the second positioning boss 88 is forced into the first positioning recess 45 by inverting the lower case 14 by 180° from the normal fitting position with respect to the upper case 12, as is shown in Fig. 13, because a width dimension of the second positioning boss 88 in the direction of the diagonal line Lc1 is set larger than the inside dimension R1 of the first positioning recess 45 because the ribs protrusions 94a and 94b are formed, the inner protrusion portions 52 and 52 interfere with the rib protrusions 94a and 94b. Hence, insertion of the second positioning boss 88 into the first positioning recess 45 is inhibited. It thus becomes possible to lower a risk of damaging the connection terminals 22a through 22c by inhibiting the lower case 14 from being fit to the upper case 12 in a wrong direction.

Also, the positioning bosses 84 and 88 and the positioning recesses 45 and 48 are formed, respectively, in the first corner portions 44 and 82 and the second corner portions 46 and 86 located at opposing corners of the hollow case 102. Accordingly, the positioning bosses 84 and 88 and the positioning recesses 45 and 48 can be formed with high efficiency of space utilization by successfully using the first corner portions 44 and 82 and the second corner portions 46 and 86 that are often left as unused region because it is difficult to install electrical components. Hence, a positioning mechanism and an erroneous assembling preventing mechanism using the positioning bosses 84 and 88 and the positioning recesses 45 and 48 can be formed with high efficiency of space utilization.

While the embodiment of the invention has been described in detail, it should be appreciated that the invention is not limited to the specific description above. For example, with regard to specific sectional shapes of the positioning recesses and the positioning bosses, these positioning recesses and bosses can be inner protrusions and rib protrusions and are not particularly limited as long as an inside dimension of the positioning recess in the second corner portion in the direction of the diagonal line can be set larger than the inside dimension of the positioning recess in the first corner portions in the direction of the diagonal line. A circular shape including an elliptical shape and an oval shape, a rectangular shape, a polygonal shape, and other various shapes can be suitably adopted as the sectional shape.

In the embodiment above, the rib protrusions 94a and 94b protrude from the second positioning boss 88 on the both sides in the diagonal line Lc2. It should be appreciated, however, that the rib protrusion 94a alone may be provided. Further, the rattling preventing ribs 90a through 90d, 96a and 96b on the first positioning boss 84 and the second positioning boss 88 are not necessarily required. Further, the rib protrusions and the inner protrusions may be formed fully along the positioning boss and the positioning recess as the rib protrusions 94a and 94b in the embodiment above or may be formed only in the protruding tip edge portion of the positioning boss and in the opening edge portion along the positioning recess as the inner protrusions 52 and 52 in the embodiment above.

Summarizing insofar, an electric connection box of a novel structure is thus capable of providing a structure of positioning one case and the other case with respect to each other and a structure of preventing erroneous assembling while achieving a size reduction and space saving. Positioning bosses and positioning recesses are provided in first corner portions and second corner portions opposing in a direction of a diagonal line of a hollow case. An inside dimension of the positioning recess provided in the second corner portion is set larger than an inside dimension in the direction of the diagonal line of the positioning recess provided in the first corner portion. A rib protrusion of the positioning boss in the second corner portion is allowed to be fit into a fitting recess groove provided to the positioning recess in the second corner portion and also allowed to interfere with inner protrusions provided to the positioning recess provided in the first corner portion

### [Description of major or important Reference Numerals and Signs]

10: electrical connection box
12: upper case (one case)
14: lower case (the other case)
16: bus bar circuit (internal circuit body)
22a through 22c: connection terminals
32: bottom plate
34: circumferential wall (the other case)
35: outer surface
38: terminal insertion hole
44 and 82: first corner portions
45: first positioning recess
46 and 86: second corner portions
48: second positioning recess
50: first tube body
52: inner protrusion
54: second tube body
60: fitting recess groove
66: circumferential wall (one case)
84: first positioning boss
88: second positioning boss
90a through 90d: rattling preventing ribs
94a and 94b: rib protrusions
96a and 96b: rattling preventing ribs
100: tip end portion
102: hollow case

## Claims

1. An electric connection box in which an internal circuit body (16) is housed within a rectangular hollow case formed by fitting one case (12) and an other case (14) together and the one case and the other case are positioned with respect to each other by fitting at least one positioning boss (84, 88) provided to an interior of the one case (12) into at least one positioning recess (45, 48) provided to an interior of the other case, the electric connection box being **characterized in that**:
the positioning boss and the positioning recess are provided in each of a first corner portion (44, 82) and a second corner portion (46, 86) that oppose in a direction of a diagonal line (Lc1) of the hollow case;
an inside dimension in the direction of the diagonal line of the positioning recess (48) provided in the second corner portion is set larger than an inside dimension in the direction of the diagonal line of the positioning recess (45) provided in the first corner portion;
a rib protrusion (94a, 94b) protruding in the direction of the diagonal line is provided on an outer peripheral surface of the positioning boss (88) provided in the second corner portion;
a fitting recess groove (60) into which the rib protrusion is inserted is provided to the positioning recess provided in the second corner portion; and
the positioning recess provided in the first corner portion is provided with an inner protrusion (52) protruding inward in the direction of the diagonal line.

2. The electric connection box according to claim 1, wherein:
the positioning recess (45) provided in the first corner portion extends in a circular shape in cross section;
the positioning recess (48) provided in the second corner portion extends in an elliptical shape in cross section having a long axis extending in the direction of the diagonal line (Lc1); and
the positioning boss extends in a cylindrical shape having an outside diameter smaller than the cross section of the circular shape of the positioning recess provided in the first corner portion.

## Patentansprüche

1. Ein elektrischer Anschlusskasten, bei welchem ein interner Schaltkreiskörper (16) innerhalb eines rechteckförmigen hohlen Gehäuses aufgenommen ist, welches gebildet ist durch Zusammenfügen eines Gehäuses (12) und eines anderen Gehäuses (14), wobei das eine Gehäuse und das andere Gehäuse bezüglich einander durch Einfügen wenigstens eines Positionierstifts (84, 88) im Inneren des einen Gehäuses (12) in wenigstens eine Positioniervertiefung (45, 48) im Inneren des anderen Gehäuses bezüglich einander positioniert sind, wobei der elektrische Anschlusskasten **dadurch gekennzeichnet ist, dass**:
der Positionierstift und die Positioniervertiefung jeweils in einem ersten Eckabschnitt (44, 82) und einem zweiten Eckabschnitt (46, 86) angeordnet sind, welche einander in Richtung einer Diagonallinie (Lc1) des hohlen Gehäuses gegenüberliegen;
eine Innenabmessung in Richtung der Diagonallinie der Positioniervertiefung (48) in dem zweiten Eckabschnitt größer als eine Innenabmessung in Richtung der Diagonallinie der Positioniervertiefung (45) in dem ersten Eckabschnitt ist;
eine Vorsprungsrippe (94a, 94b), welche in Richtung der Diagonallinie vorsteht, an einer äußeren Umfangsoberfläche des Positionierstifts (88) in dem zweiten Eckabschnitt angeordnet ist;
eine Passvertiefung (60), in welche die Vorsprungsrippe eingesetzt wird, an der Positioniervertiefung in dem zweiten Eckabschnitt angeordnet ist; und
die Positioniervertiefung in dem ersten Eckabschnitt mit einem inneren Vorsprung (52) versehen ist, der in Richtung der Diagonallinie nach innen vorsteht.

2. Der elektrische Anschlusskasten nach Anspruch 1, wobei:
die Positioniervertiefung (45) in dem ersten Eckabschnitt sich im Querschnitt in einer Kreisform erstreckt;
die Positioniervertiefung (48) in dem zweiten Eckabschnitt sich im Querschnitt in einer elliptischen Form erstreckt mit einer Langachse, die sich in Richtung der Diagonallinie (Lc1) erstreckt; und
der Positionierstift sich in zylindrischer Form erstreckt mit einem kleineren Außendurchmesser als der Querschnitt der Kreisform der Positioniervertiefung in dem ersten Eckabschnitt.

## Revendications

1. Boîtier de jonction électrique dans lequel un corps de circuit interne (16) est contenu à l'intérieur d'un compartiment rectangulaire creux formé par assemblage d'un premier compartiment (12) et d'un autre compartiment (14) entre eux, et le premier compartiment et l'autre compartiment sont positionnés l'un par rapport à l'autre par assemblage d'au moins un bossage de positionnement (84, 88) agencé sur une partie interne du premier compartiment (12) dans au moins une cavité de positionnement (45, 48) agencée sur une partie interne de l'autre compartiment, le boîtier de liaison électrique est **caractérisé en ce que** :
le bossage de positionnement et la cavité de positionnement sont agencés sur chacune d'une première partie d'angle (44, 82) et d'une seconde partie d'angle (46, 86) qui sont opposées dans la direction d'une ligne diagonale (Lc1) du compartiment creux ;
une dimension interne dans la direction de la ligne diagonale de la cavité de positionnement (48) agencée sur la seconde partie d'angle est définie de manière à être supérieure à une dimension interne dans la direction de la ligne diagonale de la cavité de positionnement (45) agencée sur la première partie d'angle ;
une saillie en nervure (94a, 94b) s'étendant dans la direction de la ligne diagonale est formée sur une surface périphérique externe du bossage de positionnement (88) agencé sur la seconde partie d'angle ;
une rainure en cavité conjuguée (60), dans laquelle la saillie en nervure est insérée, est formée sur la cavité de positionnement agencée sur la seconde partie d'angle ; et
la cavité de positionnement agencée sur la première partie d'angle comporte une saillie interne (52) s'étendant vers l'intérieur suivant la direction de la ligne diagonale.

2. Boîtier de jonction électrique selon la revendication 1, dans lequel :
la cavité de positionnement (45) agencée sur la première partie d'angle s'étend, en section transversale, avec une forme circulaire ;
la cavité de positionnement (48) agencée sur la seconde partie d'angle s'étend, en section transversale, avec une forme elliptique, présentant un axe long s'étendant dans la direction de la ligne diagonale (Lc1) ; et
le bossage de positionnement s'étend suivant une forme cylindrique présentant un diamètre externe inférieur à la section transversale de la forme circulaire de la cavité de positionnement agencée sur la première partie d'angle.
